Europäisches Patentamt

European Patent Office

Office européen des brevets

(19)

(11) Veröffentlichungsnummer : **0 429 991 B1**

(12) # EUROPÄISCHE PATENTSCHRIFT

(45) Veröffentlichungstag der Patentschrift :
12.07.95 Patentblatt 95/28

(51) Int. Cl.⁶ : **H04Q 7/32,** G01R 23/00

(21) Anmeldenummer : **90121971.7**

(22) Anmeldetag : **16.11.90**

(54) **Verfahren und Vorrichtung zur Identifizierung eines sinusförmigen Impulssignals.**

(30) Priorität : **29.11.89 AT 2719/89**

(43) Veröffentlichungstag der Anmeldung :
**05.06.91 Patentblatt 91/23**

(45) Bekanntmachung des Hinweises auf die
Patenterteilung :
**12.07.95 Patentblatt 95/28**

(84) Benannte Vertragsstaaten :
**AT BE CH DE DK FR GB LI NL SE**

(56) Entgegenhaltungen :
**GB-A- 2 181 548**
**US-A- 4 038 540**
**US-A- 4 775 951**

(73) Patentinhaber : **Siemens Aktiengesellschaft**
**Österreich**
**Siemensstrasse 88 - 92**
**A-1210 Wien (AT)**
(84) **AT**
Patentinhaber : **SIEMENS**
**AKTIENGESELLSCHAFT**
**Wittelsbacherplatz 2**
**D-80333 München (DE)**
(84) **BE CH DE DK FR GB LI NL SE**

(72) Erfinder : **Tschirk, Wolfgang**
**Pelzgasse 2/13**
**A-1150 Wien (AT)**

EP 0 429 991 B1

EP 0 429 991 B1

**Beschreibung**

Die Erfindung betrifft ein Verfahren zur Identifizierung eines sinusförmigen Impulssignals bekannter Frequenz, das Teil einer frequenzmodulierten Signalfolge ist.

Für digitale Mobiltelefonnetze wird eine Trägerfrequenzgenauigkeit von 0,1 ppm gefordert. Diese Genauigkeit wäre aber nur durch ein Zeitnormal zu erreichen, das temperaturstabilisiert ist. Um eine Synchronisierung zu ermöglichen, wird von den Basisstationen des Netzes in periodischen Abständen ein "pure sine wave (PSW)-burst" mit einer entsprechenden Frequenz innerhalb eines Übertragungsrahmens gesendet. Im Empfangsteil der Mobilstation muß die Trägerfrequenz nun so eingestellt werden, daß sie von der Frequenz des PSW-bursts um höchstens $10^{-7}$ abweicht. Nach dem Einschalten des Mobiltelefons ist eine Erstsynchronisation auf den PSW-burst durchzuführen. Aufgrund von Unregelmäßigkeiten bei der Funkübertragung ist von Zeit zu Zeit auch eine Korrektursynchronisation durchzuführen, um den PSW-burst sicher zu empfangen.

Der Erfindung liegt die Aufgabe zugrunde, das sinusförmige Impulssignal des PSW-bursts aus einer Signalfolge zu erkennen.

Dies wird erfindungsgemäß dadurch erreicht, daß die Signalfolge digitalisiert wird und Signalwerte gebildet werden, daß laufend der Autokorrelationsfunktionwert der Signalfolge für eine Verschiebung um eine Periodenlänge des Signals als Periodenwert und der Autokorrelationsfunktionwert für eine Verschiebung um einen Abtastzeitraum als Periodenteilwert ermittelt werden und daß der Periodenwert mit dem Periodenteilwert verglichen wird, wobei der Beginn des Impulssignals identifiziert ist, wenn der Periodenwert größer als der Periodenteilwert wird.

Vom erfindungsgemäßen Verfahren werden die unterschiedlichen Autokorrelationseigenschaften eines sinusförmigen und eines frequenzmodulierten Signals genutzt. Die Autokorrelationsfunktion einer Zeitfunktion nimmt bei modulierten (breitbandigen) Signalen mit wachsendem Variablenwert ab. Beim periodischen Signal ist die Funktion ebenfalls periodisch, wobei die Periode gleich der Periode des Ausgangssignals ist.

Zur besseren Anpassung des erfindungsgemäßen Verfahrens an unterschiedliche Realisierungen ist es vorteilhaft, daß die Signalwerte in einem Speicher zyklisch abgespeichert werden und die Abspeicherung nach dem Beginn des Impulssignals mit dem Absinken des Periodenwertes unter den Periodenteilwert unterbrochen wird und daß aus dem größten Periodenwert die Lage der Abtastwerte des Impulssignals ermittelt und ein Zeitglied rückgesetzt wird. So enthält der Speicher die Abtastwerte der zuletzt abgelaufenen Zeitspanne, innerhalb der ein PSW-burst gesendet wurde. Seine genaue Lage kann unabhängig vom Empfang der weiteren Signalfolge ermittelt werden.

Um nur eine möglichst kurze Signalfolge speichern zu müssen, muß die Erstsynchronisation in Echtzeit erfolgen. Daher entfallen weitgehend konventionelle Methoden digitaler Filterung. Zur schnellen Identifizierung des Impulssignals ist es vorteilhaft, daß die Autokorrelationsfunktion durch Ergänzung mit einer exponentiellen Fensterfunktion verallgemeinert und zur Ermittlung der Perioden- und Periodenteilwerte eine Rekursionsformel verwendet wird.

Es werden bereits verschiedene Verfahren und Vorrichtungen zur Trägerfrequenzkorrektur für digitale Mobiltelefone mit Hilfe des PWS-bursts vorgeschlagen. Der Erfindung liegt daher weiter die Aufgabe zugrunde, daß Identifizierungsverfahren mit vorgeschlagenen Vorrichtungen kombinieren zu können.

Dies wird durch eine Vorrichtung zur Identifizierung eines sinusförmigen Impulssignals bekannter Frequenz, aus dem eine Trägerfrequenzkorrektur für digitale Mobiltelefone ableitbar ist, wobei im Empfangsteil des Mobiltelefons ein Frequenzumsetzer vorhanden ist, dem ein Analog/Digital-Wandler und ein Signalprozessor nachgeordnet ist, erreicht, die dadurch gekennzeichnet ist, daß der Signalprozessor einen Impulssignaldetektor und einen Trägerfrequenzgenerator enthält, daß ein Speicher zwischen den Analog/Digital-Wandler und den Signalprozessor geschaltet ist und mit Prozessoreingängen des Impulssignaldetektors und des Trägerfrequenzgenerators verbunden ist und daß ein rücksetzbares Zeitglied mit dem Signalprozessor verbunden ist.

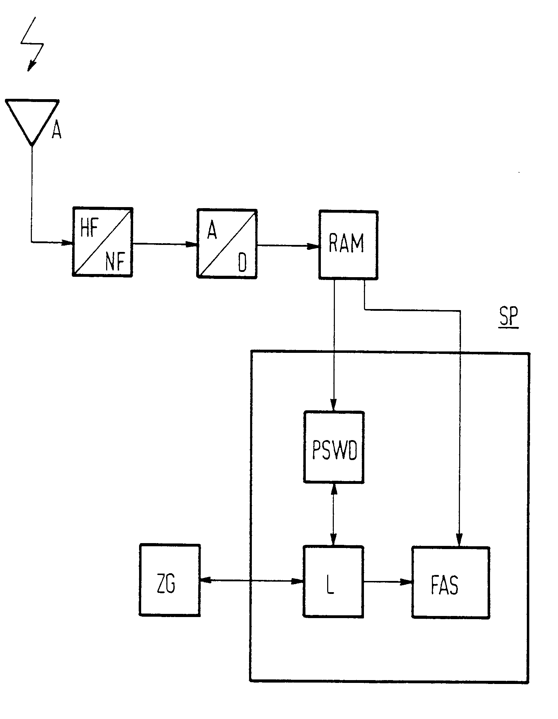

Die Erfindung wird anhand eines Ausführungsbeispieles und einer Figur näher erläutert. Die Figur zeigt das Prinzipschaltbild des Ausführungsbeispieles.

Die Fig. zeigt einen Empfangsteil eines digitalen Mobiltelefons, bestehend aus einer Antenne A, der ein Frequenzumsetzer HF/NF nachgeordnet ist. Die ankommende Signalfolge wird auf eine Frequenz von 32 kHz heruntergesetzt. Die Toleranz beträgt $\pm$ 900 Hz. Das Niederfrequenzsignal wird mit einer Rate von 512 kHz in einem nachgeschalteten Analog/Digital-wandler A/D abgetastet, und die Signalwerte werden in einen Speicher RAM von 512 bytes zyklisch abgelegt. Die Abspeicherung in den Speicher RAM wird unterbrochen, wenn das Ende eines PSW-bursts detektiert wird. Der Speicher RAM enthält dann die Signalwerte der letzten Millisekunde. Unter diesen befinden sich auch die Werte des PSW-bursts. Seine genaue Lage wird durch das Aufsuchen des Maximums von Periodenwerten einer Quasi-Autokorrelationsfunktion ermittelt. Nachdem der PSW-burst lokalisiert ist, wird ein Zeitglied ZG vom Signalprozessor SP zurückgesetzt und die Speicheradres-

2

se des letzten Impulssignals-Abtastwertes an einen Trägerfrequenzgenerator FAS übergeben.

Die Autokorrelationsfunktion acf von g(x) einer Zeitfunktion g(t) ist durch die folgende Formel definiert:

$$acf_g(x) = \lim_{T=>\infty} (1/T) . \int_{-T/2}^{T/2} g(t).g(t-x)\ dt$$

Für die Abtastwerte der Zeitfunktion g(t) ist die Autokorrelationsfunktion acf von g(k) definiert durch:

$$acf_g(k) = \lim_{N=>\infty} (1/(2N+1)) . \sum_{n=-N}^{N} g[nT].g[(n-k)T]$$

wobei T die Abtastperiode ist. Für eine Sinusfunktion der Periode P folgt daraus, daß die Autokorrelationsfunktion anwächst und der Periodenwert acf(P) größer als der Periodenteilwert acf(P/16) ist. Für nichtperiodische Funktionen mit Nahkorrelation, z.B. für allgemein bandbegrenzte Signale, nimmt die Autokorrelation im statistischen Sinn für den Erwartungswert ab. Überlagertes weißes Rauschen stellt keine Störung der Autokorrelation dar.

Entsprechend der Relation zwischen der Abtastrate des Analog/ Digital-Wandlers A/D und der Frequenz des Impulssignals beträgt die Periode des Impulssignals $16 \pm 0,45$ Abtastungen. Zwischen dem Abtastwert, bei dem erstmals der Periodenwert größer als der Periodenteilwert ist und jenem, wo dies erstmals wieder nicht erfüllt ist, liegt das Maximum der Autokorrelationsfunktion und damit das Ende der Trägerfrequenz-Korrekturfolge. Dieses Maximum wird von einer Logikschaltung L ermittelt. Um die Stabilität des Algorithmus zu verbessern, werden die beiden Hysteresekonstanten $h \geqq 1$ und h2<1 eingeführt.

Wegen der Abtastrate von 512 kHz bleibt zwischen zwei aufeinanderfolgenden Abtastungen lediglich eine Rechenzeit von 1,95 μs. Das sind bei den schnellsten derzeit verfügbaren Signalprozessoren SP 19 Arbeitszyklen. Daher läßt sich die

Berechnung der Autokorrelationswerte nicht bewerkstelligen. Aus einer Verallgemeinerung der Autokorrelationsfunktion ist aber eine Quasi-Autokorrelationsfunktion zu gewinnen. Diese bietet die Möglichkeit einer rekursiven Berechnung. Die Definition der Quasi-Autokorrelationsfunktion aqf für zeitdiskrete Signale g(nT) lautet:

$$aqf_g(k,j) = \sum_{n=0}^{j} f(j-n).g[nT].g[(n-k)T]$$

Der Zeitindex j trägt der Tatsache Rechnung, daß der Wert der Quasi-Autokorrelationsfunktion vom Berechnungszeitpunkt abhängt. f ist eine Fensterfunktion. Bei der Verwendung einer exponentiellen Fensterfunktion ergibt sich

$$aqf_g(k,j) = r.aqf_g(k, j - l) + g[jT].g[(j - k)T]$$

Die Quasi-Autokorrelationsfunktion hat qualitativ etwa die gleichen Eigenschaften wie die Autokorrelationsfunktion. Der Trägerfrequenzgenerator FAS benötigt mindestens 247 Werte des PSW-bursts zur Frequenzanpassung. Die theoretisch maximal erhältliche Anzahl korrekter Werte beträgt 275. Durch das erfindungsgemäße Identifizierungsverfahren werden je nach Signal/Rausch-Verhältnis 257 bis 274 Werte zur Verfügung gestellt.

**Patentansprüche**

1. Verfahren zur Identifizierung eines sinusförmigen Impulssignals bekannter Frequenz, das Teil einer frequenzmodulierten Signalfolge ist, **dadurch gekennzeichnet**, daß die Signalfolge digitalisiert wird und Signalwerte gebildet werden, daß laufend der Autokorrelationsfunktionswert der Signalfolge für eine Verschiebung um eine Periodenlänge des Signals als Periodenwert und der Autokorrelationsfunktionswert für eine Verschiebung um einen Abtastzeitraum als Periodenteilwert ermittelt werden und daß der Periodenwert mit dem Periodenteilwert verglichen wird, wobei der Beginn des Impulssignals identifiziert ist, wenn der Periodenwert größer als der Periodenteilwert wird.

2. Verfahren nach Anspruch 1, **dadurch gekennzeichnet**, daß die Signalwerte in einem Speicher (RAM) zyklisch abgespeichert werden und die Abspeicherung nach dem Beginn des Impulssignals mit dem Absinken des Periodenwertes unter den Periodenteilwert unterbrochen wird und daß aus dem größten Periodenwert die Lage der Abtastwerte des Impulssignals ermittelt und ein Zeitglied (ZG) rückgesetzt wird.

3. Verfahren nach Anspruch 1 oder 2, **dadurch gekennzeichnet**, daß die Autokorrelationsfunktion durch Ergänzung mit einer exponentiellen Fensterfunktion verallgemeinert und zur Ermittlung des Perioden- und Periodenteilwertes eine Rekursionsformel verwendet wird.

4. Vorrichtung zur Identifizierung eines sinusförmigen Impulssignals bekannter Frequenz, aus dem eine Trägerfrequenzkorrektur für digitale Mobiltelefone ableitbar ist, wobei im Empfangsteil des Mobiltelefons ein Frequenzumsetzer (HF/NF) vorhanden ist, dem ein Analog/Digital-Wandler (A/D) und ein Signalprozessor (SP) nachgeordnet ist, **dadurch gekennzeichnet**, daß der Signalprozessor (SP) einen Impulssignaldetektor (PSWD) und einen Trägerfrequenzgenerator (FAS) enthält, daß ein Speicher (RAM) zwischen den Analog/Digital-Wandler (A/D) und den Signalprozessor (SP) geschaltet und mit Prozessoreingängen des Impulssignaldetektors (PSWD) und des Trägerfrequenzgenerators (FAS) verbunden ist und daß ein rücksetzbares Zeitglied (ZG) mit dem Signalprozessor (SP) verbunden ist.

## Claims

1. Method for identifying a sinusoidal pulse signal of known frequency, which is part of a frequency-modulated signal sequence, characterized in that the signal sequence is digitized and signal values are formed, in that the autocorrelation function value of the signal sequence is continuously determined as period value for a shift by a period length of the signal, and the autocorrelation function value is continuously determined as partial period value for a shift by a sampling time, and in that the period value is compared with the partial period value, the start of the pulse signal being identified when the period value becomes greater than the partial period value.

2. Method according to Claim 1, characterized in that the signal values are cyclically stored in a memory (RAM) and the storage is interrupted after the start of the pulse signal with the dropping of the period value below the partial period value, and in that the position of the sampled values of the pulse signal is determined from the largest period value and a timing element (ZG) is reset.

3. Method according to Claim 1 or 2, characterized in that the autocorrelation function is generalized by being supplemented with an exponential window function, and a recurrence formula is used to determine the period value and partial period value.

4. Device for identifying a sinusoidal pulse signal of known frequency from which a carrier frequency correction for digital mobile telephones can be derived, there being present in the receiving part of the mobile telephone a frequency converter (HF/NF) downstream of which an analog-to-digital converter (A/D) and a signal processor (SP) are arranged, characterized in that the signal processor (SP) contains a pulse signal detector (PSWD) and a carrier frequency generator (FAS), in that a memory (RAM) is connected between the analog-to-digital converter (A/D) and the signal processor (SP) and is connected to processor inputs of the pulse signal detector (PSWD) and of the carrier frequency generator (FAS), and in that a resettable timing element (ZG) is connected to the signal processor (SP).

## Revendications

1. Procédé pour identifier un signal impulsionnel sinusoïdal de fréquence connue, qui fait partie d'une suite de signaux modulés en fréquence, caractérisé par le fait qu'on numérise la suite de signaux et qu'on forme des valeurs de signaux, qu'on détermine en permanence la valeur de la fonction d'autocorrélation de la suite de signaux pour un décalage d'une longueur de la période du signal en tant que valeur de période et la valeur de la fonction d'autocorrélation pour un décalage sur un intervalle de temps de balayage en tant que valeur de fraction de la période et que l'on compare la valeur de la période à la valeur de fraction de la période, le début du signal impulsionnel étant identifié lorsque la valeur de la période est supérieure à la valeur de fraction de la période.

2. Procédé suivant la revendication 1, caractérisé par le fait qu'on mémorise cycliquement des valeurs de signal dans une mémoire (RAM) et qu'on interrompt la mémorisation après le début du signal impulsionnel lorsque la valeur de la période tombe au-dessous de la valeur de fraction de la période, et que la position de la valeur d'échantillonnage du signal impulsionnel est déterminée à partir de la valeur maximale de cette période et qu'un circuit de temporisation (ZG) est ramené à zéro.

3. Procédé suivant la revendication 1 ou 2, caractérisé par le fait qu'on généralise la fonction d'autocorrélation en la complétant par une fonction fenêtre exponentielle et que pour la détermination de la valeur de la période ou de la valeur de fraction de la période, on utilise une formule récursive.

4. Dispositif pour identifier un signal impulsionnel sinusoïdal de fréquence connue, à partir duquel peut être dérivée une correction de la fréquence porteuse pour des téléphones numériques mobiles, et dans lequel dans la partie de réception du téléphone mobile est présent un convertisseur de fréquence (HF/NF), en aval duquel sont disposés un convertisseur analogique/numérique (A/D) et un processeur de signaux (SP), caractérisé par le fait que le processeur de signaux (SP) comporte un détecteur (PSWD) de signaux impulsionnels et un générateur (FAS) de fréquence porteuse, qu'une mémoire (RAM) est branchée entre le convertisseur analogique/numérique (A/D) et le processeur de signaux (SP) et est reliée à des entrées de processeurs du détecteur (PSWD) de signaux impulsionnels et du générateur (FAS) de fréquence porteuse et qu'un circuit de temporisation (ZG) pouvant être ramené à zéro est relié au processeur de signaux (SP).